(19) Europäisches Patentamt / European Patent Office / Office européen des brevets

(11) **EP 3 308 177 B1**

(12) **FASCICULE DE BREVET EUROPEEN**

(45) Date de publication et mention de la délivrance du brevet:
**06.10.2021 Bulletin 2021/40**

(21) Numéro de dépôt: **16734416.7**

(22) Date de dépôt: **31.05.2016**

(51) Int Cl.:
**B60L 3/12** *(2006.01)*    **G01R 31/52** *(2020.01)*
**G01R 27/02** *(2006.01)*    **B60L 3/00** *(2019.01)*
**G01R 31/00** *(2006.01)*

(86) Numéro de dépôt international:
**PCT/FR2016/051293**

(87) Numéro de publication internationale:
**WO 2016/203128 (22.12.2016 Gazette 2016/51)**

(54) **SYSTÈME ÉLECTRIQUE COMPORTANT UN CIRCUIT DE DÉTECTION D'UN DÉFAUT D'ISOLEMENT ÉLECTRIQUE**

ELEKTRISCHES SYSTEM MIT EINER SCHALTUNG ZUM ERFASSEN EINES ELEKTRISCHEN ISOLATIONSFEHLERS

ELECTRICAL SYSTEM COMPRISING A CIRCUIT FOR DETECTING AN ELECTRICAL INSULATION FAULT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.06.2015 FR 1555417**

(43) Date de publication de la demande:
**18.04.2018 Bulletin 2018/16**

(73) Titulaire: **Renault S.A.S.**
**92100 Boulogne-Billancourt (FR)**

(72) Inventeurs:
• **GARDIEN, François**
  **38140 Saint Martin D'uriage (FR)**
• **JOURNET, Thibaut**
  **73100 Aix-les-bains (FR)**
• **LE VOURCH, Yves**
  **78150 Le Chesnay (FR)**
• **PALMIERI, Michael**
  **38610 Gieres (FR)**
• **RIVET, Sophie**
  **78280 Guyancourt (FR)**

(74) Mandataire: **INNOV-GROUP**
**310, avenue Berthelot**
**69372 Lyon Cedex 08 (FR)**

(56) Documents cités:
WO-A1-2014/086381    FR-A1- 2 976 084
FR-A1- 2 995 083    US-A1- 2013 300 430
US-A1- 2013 314 097

**Description**

L'invention concerne l'isolement d'un réseau ou d'une alimentation électrique à tension continue par rapport à une référence de tension.

Les systèmes électriques de forte puissance à tension continue connaissent un développement important. En effet, de nombreux systèmes de transport incluent une alimentation de tension continue.

Les véhicules hybrides combustion/électrique ou électriques incluent notamment des batteries de forte puissance. Pour obtenir le niveau de tension adéquat, on place en série plusieurs accumulateurs électrochimiques. Pour obtenir de fortes puissances et capacités, on place plusieurs groupes d'accumulateurs en série. Le nombre d'étages (nombre de groupes d'accumulateurs) et le nombre d'accumulateurs en parallèle dans chaque étage varient en fonction de la tension, du courant et de la capacité souhaités pour la batterie. L'association de plusieurs accumulateurs est appelée une batterie d'accumulateurs.

De telles batteries sont généralement utilisées pour entraîner un moteur électrique à courant alternatif par l'intermédiaire d'un onduleur. Les niveaux de tension nécessaires pour de tels moteurs atteignent plusieurs centaines de Volts, typiquement de l'ordre de 400 Volts. De telles batteries comportent également une forte capacité afin de favoriser l'autonomie du véhicule en mode électrique. Plusieurs raisons techniques spécifiques à l'application automobile amènent à l'utilisation d'un isolement entre la carcasse, ou masse mécanique du véhicule (formée par le châssis et la carrosserie métalliques du véhicule, et donc accessibles à l'utilisateur) et les potentiels de la batterie.

La raison principale est qu'il n'est pas envisageable lors d'un premier défaut d'isolement en roulage de déconnecter instantanément la batterie de traction. Par exemple, dans le cas où l'un des pôles de la batterie est relié à la masse mécanique et que le défaut d'isolement apparaît sur l'autre pôle. Ceci se traduit par un court-circuit et la fusion immédiate du fusible de protection. Cela aurait pour effet de rendre le véhicule dangereux, du fait de la disparition de la puissance de traction ou du freinage récupératif. Ceci oblige donc à devoir isoler la batterie et surveiller cet isolement pour des raisons de sécurité des personnes par un contrôleur d'isolement. En effet, si lors d'un premier défaut il n'y a aucun risque pour l'utilisateur, il convient de l'alerter de ce premier défaut avant l'apparition d'un second défaut ayant pour effet de déconnecter la batterie de traction car provoquant un court-circuit entre les bornes positive et négative de la batterie. De plus, lors de ce second défaut, la tension de la batterie serait directement reliée à la masse mécanique du véhicule et l'utilisateur serait donc potentiellement en contact avec celle-ci. Du fait du risque potentiel d'une telle source d'énergie pour les utilisateurs, l'isolement et le contrôle de l'isolement entre la batterie et la masse mécanique doivent être particulièrement soignés. Toute partie du véhicule reliée électriquement à la batterie doit être isolée par rapport aux masses. Cet isolement est réalisé par l'utilisation de matériaux électriquement isolants. L'isolement peut se détériorer avec le temps (à cause des vibrations, des chocs mécaniques, de la poussière, etc.), et donc mettre la masse électrique sous un potentiel dangereux.

Par ailleurs, il peut être envisagé d'utiliser un chargeur non isolé galvaniquement du réseau électrique. La masse électrique du véhicule étant normativement reliée à la terre lors des recharges et le régime de neutre utilisé classiquement (régime TT) en résidentiel connectant le neutre à la terre, cela revient à connecter pendant les recharges la masse du véhicule à un des potentiels de la batterie. Pendant ces recharges, la tension complète de la batterie est donc appliquée aux bornes de l'isolement contrairement au cas nominal où seulement la moitié de cette tension est appliquée et surtout contrôlée. Cet isolement pourrait ne pas être capable de tenir la tension complète créant un second défaut instantanément ayant pour conséquence un court-circuit.

Un véhicule électrique selon l'état de la technique présente typiquement une batterie destinée à l'alimentation d'un moteur électrique triphasé. La batterie comprend des accumulateurs électrochimiques. Un dispositif de protection muni de fusibles est connecté aux bornes de la batterie. Un dispositif de contrôle d'isolement (ou circuit de détection d'un défaut d'isolement) est également connecté aux bornes de la batterie et raccordé à la masse du véhicule. Le dispositif de contrôle d'isolement est connecté à un calculateur pour lui signaler les défauts d'isolement détectés. Ce calculateur est alimenté par une batterie de réseau de bord. Le pôle négatif de cette batterie est relié à la masse du véhicule. Le système de coupure comprend des contacteurs de puissance commandés par le calculateur.

Deux types de circuits de contrôle d'isolement sont connus de l'état de la technique :

- des circuits à mesure résistive, dans lesquels un courant de fuite est mesuré à l'aide d'un pont diviseur de tension formé d'une pluralité de résistances connectées entre les bornes de la batterie ;
- des circuits à mesure par décharge capacitive, dans lesquels un courant électrique est injecté depuis un condensateur dans la résistance d'isolement puis le temps de décharge de ce condensateur dans la résistance d'isolement est mesuré.

Les circuits à mesure résistive ont pour inconvénient qu'ils nécessitent d'être connectés aux deux bornes de la batterie, ce qui complique leur intégration au sein du véhicule. En outre, ils ne permettent typiquement pas de détecter un défaut en tout point de la batterie.

Les circuits à mesure capacitive présentent quant à eux d'autres inconvénients. En particulier, la valeur de capacité des condensateurs électrochimiques typiquement utilisés industriellement n'est généralement pas stable et tend à dériver dans le temps, ce qui fausse les calculs. En outre, de tels condensateurs doivent pouvoir résister à une tension électrique élevée, typiquement de l'ordre de plusieurs centaines de volts, et ce pour des raisons de sécurité au cas où un court-circuit se produirait. De tels condensateurs présentent généralement un coût élevé et un encombrement très important. En outre, un tel circuit ne permet généralement pas de localiser la position du défaut dans la batterie.

Le document WO2014/086381 décrit un système électrique destiné à être connecté à une source d'énergie électrique embarquée, et muni d'un circuit de détection d'un défaut d'isolement électrique entre sept sources et une carcasse formant une masse électrique flottante. Le système comprend une résistance calibrée connectée sélectivement entre la carcasse et une borne de la source. La tension aux bornes de cette résistance permet de déterminer l'amplitude d'un défaut d'isolement. Un tel système est incapable de mesurer un courant de défaut d'isolement provenant d'un point intermédiaire de la source.

Le document US2013/0300430 décrit un système d'analyse de défaut d'isolement. Le système connecte séquentiellement chaque borne d'une source au châssis, par l'intermédiaire de résistances calibrées et d'interrupteurs respectifs. La tension aux bornes de chaque résistance permet de déterminer l'amplitude d'un défaut d'isolement. Une telle solution n'est pas totalement satisfaisante pour un courant de défaut d'isolement provenant d'un point intermédiaire de la source.

Le document FR2976084 décrit un système de détection de défaut d'isolement pour une source de tension. Le système de détection comprend des limiteurs de courant connectant sélectivement chaque borne de la source à un châssis. Un tel système est incapable de mesurer un courant de défaut d'isolement provenant d'un point intermédiaire de la source.

Le document US2013/0314097 décrit un système d'analyse de défaut d'isolement. Le système connecte séquentiellement chaque borne d'une source au châssis, par l'intermédiaire de résistances calibrées et d'interrupteurs respectifs. Un tel système est incapable de mesurer un courant de défaut d'isolement provenant d'un point intermédiaire de la source.

L'invention vise à résoudre un ou plusieurs de ces inconvénients. L'invention porte ainsi sur un système électrique tel que défini dans la revendication 1 annexée. L'invention porte également sur les variantes des revendications dépendantes. L'homme du métier comprendra que chacune des caractéristiques des variantes des revendications dépendantes peut être combinée indépendamment aux caractéristiques de la revendication 1, sans pour autant constituer une généralisation intermédiaire.

Selon un autre aspect, l'invention concerne un procédé de détection d'un défaut d'isolement entre une source d'énergie électrique embarquée et une carcasse formant une masse électrique flottante, tel que défini dans les revendications annexées.

D'autres caractéristiques et avantages de l'invention ressortiront clairement de la description qui en est faite ci-après, à titre indicatif et nullement limitatif, en référence aux dessins annexés, dans lesquels :

- la figure 1 illustre schématiquement un véhicule automobile électrique comportant une source électrique de tension continue et un circuit de détection d'un défaut d'isolement électrique de cette source ;
- la figure 2 illustre schématiquement un défaut d'isolement dans la source électrique de tension continue de la figure 1 ;
- la figure 3 illustre schématiquement le circuit de détection de la figure 1 ;
- la figure 4 illustre schématiquement un exemple d'un procédé d'utilisation du circuit de la figure 3 pour détecter un défaut d'isolement ;
- la figure 5 illustre schématiquement l'évolution temporelle d'une grandeur représentative du courant électrique qui circule dans une résistance d'isolement du véhicule de la figure 1 en réponse à un courant injecté par le circuit de détection de la figure 1 ;
- la figure 6 un autre mode de réalisation du circuit de détection de la figure 3 ;
- la figure 7 illustre schématiquement l'utilisation du circuit de détection de la figure 6 pour détecter un défaut d'isolement dans un circuit comportant un onduleur ;
- la figure 8 illustre schématiquement une pluralité de défauts d'isolement dans la source électrique de tension continue de la figure 1.

Dans cette description, les caractéristiques et fonctions bien connues de l'homme du métier ne sont pas décrites en détail.

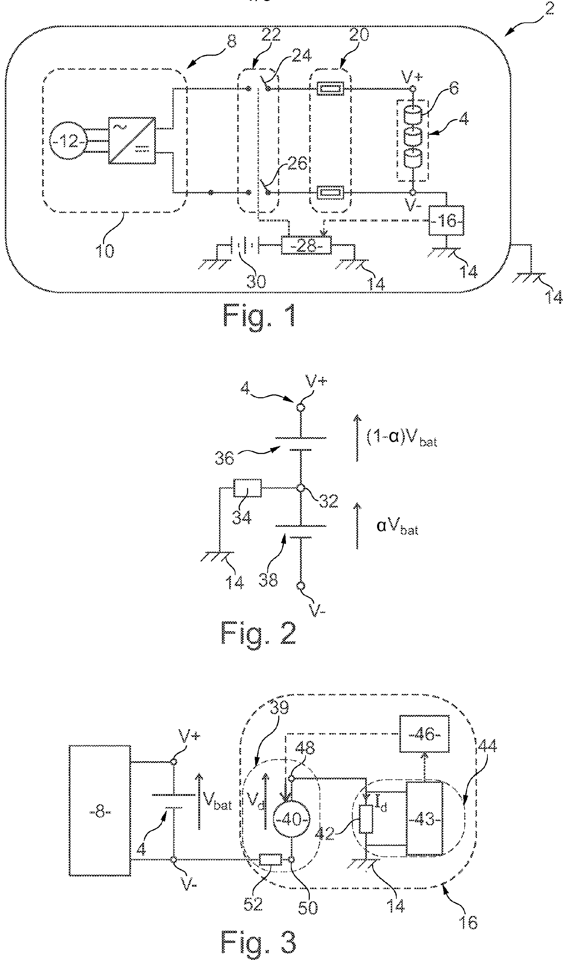

La figure 1 représente schématiquement un véhicule 2 automobile à propulsion électrique.

Ce véhicule 2 comporte un système électrique pour assurer son alimentation électrique. Ce système comporte une source 4 d'énergie électrique embarquée connectée entre deux bornes V- et V+. Par « embarquée », on entend que la source n'est pas connectée en permanence à un réseau de distribution électrique (« power grid » en anglais). La source 4 est ici apte à délivrer une tension électrique continue Vbat dont la valeur reste constante au cours du temps.

La source 4 est ici une batterie rechargeable d'accumulateurs 6 connectés en série les uns avec les autres entre les bornes V- et V+ au moyen de connexions électriques de puissance. Pour simplifier, sur la figure 1, seuls trois exemplaires de l'accumulateur 6 sont dessinés. En pratique, cependant, la batterie comporte un grand nombre d'accumulateurs 6, par exemple entre 40 et 150 accumulateurs. Le nombre d'accumulateurs dépend de la tension Vbat que l'on souhaite obtenir ainsi que des caractéristiques des accumulateurs 6. La tension Vbat est typiquement supérieure ou égale à 100V ou à 400V lorsque la batterie est chargée. Dans cet exemple, la tension Vbat est égale à 400V.

Les bornes V+, V- sont connectées électriquement à une charge électrique 8 pour alimenter électriquement cette charge 8. Dans cet exemple, la charge 8 comporte un onduleur 10 et un moteur électrique 12, tel qu'un moteur asynchrone triphasé. L'onduleur 10 convertit la tension Vbat continue qu'il reçoit en une tension alternative pour alimenter le moteur 12. Le moteur 12 propulse le véhicule 2.

Ce véhicule 2 comporte une carcasse 14, ici formée par le châssis et la carrosserie de ce véhicule 2, qui sont généralement réalisés en matière métallique électriquement conductrice. Cette carcasse 14 forme une masse électrique flottante. La carcasse 14 n'est donc pas reliée électriquement en permanence à la terre.

Le système électrique comporte en outre un circuit de détection 16 d'un défaut d'isolement entre la source 4 et la carcasse 14. Le circuit 16 est raccordé électriquement à la carcasse 14 et à une unique borne de la source 4, ici la borne V-. Ce circuit 16 sera décrit plus en détail dans ce qui suit.

Dans cet exemple, le véhicule 2 comporte en outre un circuit de protection 20 et un circuit d'accouplement de puissance 22. Le circuit 20 inclut de façon connue en soi des fusibles configurés pour rompre la connexion lors d'un court-circuit. Le circuit 22 comprend des interrupteurs 24 et 26 permettant de connecter et, en alternance, déconnecter sélectivement les bornes de la batterie 4 à l'onduleur 10. L'ouverture et la fermeture sélective des interrupteurs 24 et 26 est ici commandée par un gestionnaire de batterie 28 (« battery management system », ou « BMS » en anglais). Ce gestionnaire 28 est typiquement alimenté par l'intermédiaire d'une batterie 30 d'alimentation du réseau de bord du véhicule 2, présentant un niveau de tension très inférieur à celui de la source 4. Le gestionnaire 28 est ici raccordé au circuit 16, par exemple au moyen d'une liaison d'échange de données, pour commander l'ouverture des interrupteurs 24 et 26 au cas où un défaut d'isolement est détecté par le circuit 16.

Par défaut d'isolement, on entend ici la présence anormale d'un contact électrique de faible résistance électrique entre la carcasse 14 et un point de potentiel électrique de la source 4, tel que l'une des bornes V+, V-. Ici, la résistance est dite faible si elle est inférieure ou égale à un seuil de sécurité prédéfini, par exemple 100k$\Omega$.

Typiquement, en l'absence de défaut d'isolement, la résistance entre la carcasse 14 d'une part et tout point de potentiel de la source 4 d'autre part est supérieure à 100k$\Omega$ ou à 1M$\Omega$. Alternativement, on peut modéliser cette résistance comme une résistance de valeur infinie. Du fait de cette valeur de résistance élevée, aucun courant de fuite susceptible de poser un danger ne circule entre la source 4 et la carcasse 14.

La figure 2 illustre un unique défaut d'isolement entre un point 32 de la source 4 et la carcasse 14. Ce défaut d'isolement se traduit ici par le fait que la résistance d'isolement 34 qui raccorde ce point 32 et la carcasse 14 présente une valeur, notée Ri, inférieure au seuil de sécurité. Un courant de fuite potentiellement dangereux s'écoule au travers de cette résistance 34 depuis la source 4 vers la carcasse 14. Un tel courant de fuite est indésirable et peut mettre en danger un utilisateur du véhicule 2 qui entrerait en contact direct avec la carcasse 14 (qui est ici reliée à la carrosserie du véhicule 2).

Par exemple, le point 32 est situé entre deux accumulateurs adjacents de la source 4. La source 4 peut alors être assimilée à deux sources de tension continue 36 et 38 connectées en série l'une avec l'autre entre les bornes V+, V- et de part et d'autre du point 32. Les sources 36, 38 délivrent respectivement entre leurs bornes des tensions (1-$\alpha$)*Vbat et $\alpha$*Vbat où le coefficient $\alpha$ est un nombre réel appartenant à l'intervalle [0 ; 1]. La connaissance du coefficient $\alpha$ permet de connaître la position du défaut dans la source 4. Plus précisément, le coefficient $\alpha$ représente un barycentre de la position des défauts d'isolements dans la source 4 pondérés par leurs conductances életriques respectives.

La figure 3 représente un mode de réalisation du circuit 16. Ce circuit 16 comporte ici :

-   un dispositif 39 pour appliquer une tension entre la borne V- et la carcasse, afin si nécessaire de générer une différence de potentiel aux bornes de la résistance 34 et par suite induire la circulation d'un courant électrique à travers cette résistance 34 ;
-   des résistances 42 et 52, dont le rôle sera explicité dans ce qui suit ;
-   un dispositif 44 de mesure d'un courant électrique qui circule à travers la borne V- et la résistance 34.
-   une unité de commande 46.

Le dispositif 39 comporte ici un générateur 40 de tension commandable et la résistance électrique 52. Le générateur 40 de tension est capable d'imposer une différence de potentiel contrôlée entre ses bornes, au contraire de résistances passives rencontrées dans l'état de la technique. Le générateur 40 est apte à appliquer une tension électrique Vd entre des pôles 48, 50, en fonction d'un signal de commande reçu sur une interface de commande. Dans cet exemple, la tension Vd est continue. La valeur de Vd est de préférence inférieure ou égale à 50V, par exemple comprise entre 0V et 24V. La tension Vd est appliquée de telle sorte que le pôle 48 du générateur 40 présente un potentiel électrique plus élevé que le pôle 50 quand la tension Vd est positive.

La résistance 42 et le générateur 40 sont ici connectés en série l'un avec l'autre entre la borne V- et la carcasse 14.

Dans cet exemple, la résistance 42 est connectée entre le pôle 48 et la carcasse 14. Le pôle 50 du générateur 40 est reliée à la borne V- comme on le verra ci-après. Ainsi, l'application de la tension Vd conduit à l'apparition d'un courant électrique Id qui traverse le dispositif 44 et la résistance 34. Ce courant Id n'est cependant pas considéré comme un courant de fuite.

La résistance 52 est connectée entre la borne V- et le pôle 48. Cette résistance 52 permet d'assurer une meilleure isolation entre la source 4 et le reste du circuit 16, de façon à éviter que la valeur du courant Id ne soit trop importante et ne pose un danger à un utilisateur. La valeur, notée Rd, de cette résistance 52 est par exemple choisie la plus faible possible pour faciliter la mesure du courant Id tout en étant suffisamment élevée pour ne pas dégrader l'isolation électrique du circuit 16. On choisira de préférence une résistance Rd supérieure, par exemple 5 fois, voire 10 fois supérieure à une valeur de résistance d'isolement anormale par exemple de l'ordre de 100kOhms, pour une tension de 400V, conduisant à un courant maximal acceptable de 4mA (le courant maximal acceptable le plus élevé courrament admis pour la sécurité des personnes est de l'ordre de 10mA). Par exemple, la valeur Rd est ainsi égale à 500k$\Omega$.

La valeur de la résistance 42, notée Rs, est avantageusement choisie de sorte que le rapport Rd/Rs soit compris entre 1 et 100 ou entre 10 et 50. Ce rapport de valeurs Rd/Rs permet de maintenir au sein d'une gamme étroite les valeurs de courant Id, et donc des tensions mesurées par le dispositif 44. Cela simplifie la conception du dispositif 44. En particulier, il n'est pas nécessaire d'isoler galvaniquement le dispositif 44 si la tension mesurée par le dispositif reste inférieure ou égale à 20V ou à 10V. Par exemple, avec la tension Vbat égale à 400V et un rapport Rd/Rs égal à 100, les tensions mesurées par le dispositif 44 sont inférieures à 4V ou à 5V.

Le dispositif 44 est apte à mesurer le courant Id qui circule à travers la résistance 52 (Rd), le générateur 40, la résistance 42 (Rs) la résistance 34 et une partie de la source 4 située entre le point 32 et la borne V-. Le dispositif 44 comporte par exemple la résistance 42 et un convertisseur analogique/numérique 43 à base d'amplificateurs différentiels, connecté électriquement en parallèle avec la résistance 42. Le dispositif 44 mesure donc ici une différence de potentiel électrique Vmes aux bornes de la résistance 42. La valeur du courant qui traverse la résistance 42 en est automatiquement déduite, à partir de la connaissance préalable de la valeur Rs.

L'unité 46 est apte à :

- commander automatiquement l'application successive, par le générateur 40, d'une pluralité de valeurs différentes de la tension Vd ;
- acquérir automatiquement, pour chacune des valeurs de tension Vd appliquées par le générateur 40, la valeur du courant Id correspondant, mesurée par le dispositif 44 ;
- calculer automatiquement la valeur de la résistance 34 associée audit défaut d'isolement, à partir des valeurs de courant Id acquises et des valeurs de tension Vd appliquées.

Par exemple, l'unité 46 comporte un microprocesseur et des interfaces de communication avec le générateur 40 et le dispositif 44.

Dans cet exemple, on considère qu'il n'y a qu'un seul défaut d'isolement, situé au point 32. Deux valeurs différentes de tension Vd sont appliquées, notées Vd1 et Vd2, par le générateur 40. A chacune de ces valeurs correspond un courant Id1 et Id2 qui traverse la résistance 42. Alors, la valeur Ri de la résistance 34 est calculée au moyen de la formule suivante :

$$Ri = (Vd1 - Vd2)/(Id2 - Id1) - (Rd+Rs).$$

Cependant, en pratique, la valeur Rs peut être négligée devant la valeur Rd, et cette formule se simplifie de la manière suivante :

$$Ri = (Vd1 - Vd2)/(Id2 - Id1) - Rd \qquad [\text{équation 1}].$$

On peut également calculer la valeur du coefficient $\alpha$ au moyen de la formule suivante :

$$\alpha = (Id2*Vd1 - Id1*Vd2)/(Id2*Vbat - Id1*Vbat) \qquad [\text{équation 2}].$$

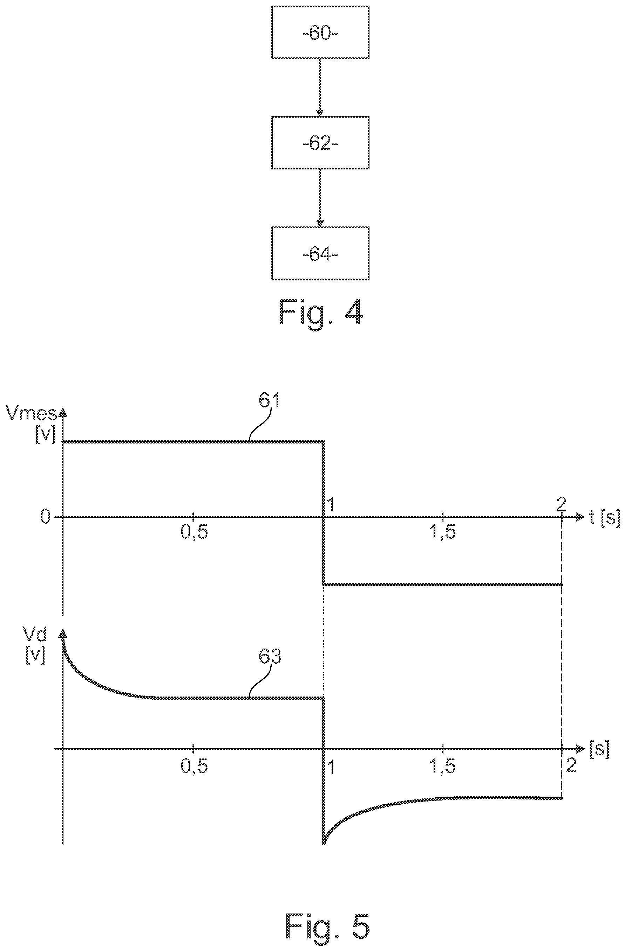

La figure 4 décrit un exemple de fonctionnement du système pour détecter le défaut d'isolement.

Lors d'une étape 60, le générateur 40 est commandé par l'unité 46 pour appliquer la tension Vd1 entre les pôles 48 et 50. Pendant que cette tension Vd1 est appliquée, le dispositif 44 mesure le courant Id1 et transmet la valeur mesurée à l'unité 46. Avantageusement, lors de cette étape, on attend que le courant Id1 se stabilise avant de le mesurer. Par exemple, on attend l'expiration d'un délai prédéterminé après l'application de Vd1 avant que le dispositif 44 ne mesure le courant Id1. En effet, lorsqu'on injecte le courant Id1 (ici en appliquant la tension Vd1), ce dernier présente d'abord une phase dite de régime transitoire, au cours de laquelle sa valeur varie de façon importante, suivie d'une phase dite de régime permanent, au cours de laquelle sa valeur se stabilise autour d'une valeur essentiellement constante. Il est préférable d'attendre que le régime permanent soit établi pour procéder à la mesure de Id1 car la précision de la mesure est alors meilleure. La valeur du délai prédéterminé dépend de la façon dont la tension Vd varie au cours du temps ainsi que du circuit 16. La durée de la phase transitoire dépend de la valeur des capacités présentes entre la source 4 et la carcasse 14. Le choix du délai prédéterminé dépend donc indirectement de la valeur de ces capacités.

La figure 5 illustre à titre d'exemple l'évolution (courbe 63) au cours du temps t (en secondes) de la tension Vmes mesurée (donc, indirectement, du courant Id1) en réponse à la tension Vd appliquée (courbe 61) qui varie de façon périodique en créneau avec une fréquence égale à 0,5Hz. Dans cet exemple, le délai prédéterminé est choisi égal à 750ms.

Ensuite, lors d'une étape 62 (figure 4), le générateur 40 est commandé par l'unité 46 pour appliquer la tension Vd2 entre les pôles 48 et 50. Pendant que cette tension Vd2 est appliquée, le dispositif 44 mesure le courant Id2 et transmet la valeur mesurée à l'unité 46. Avantageusement, comme pour le courant Id1, on attend que la valeur du courant Id2 se soit stabilisée avant de la mesurer.

Enfin, lors d'une étape 64, la résistance Ri est automatiquement calculée par l'unité 16 à partir des valeurs Vd1, Vd2, Id1 et Id2 grâce à l'équation 1 précédemment définie.

Avantageusement, lors de cette étape, est également calculé le coefficient $\alpha$ au moyen de l'équation 2 précédemment définie.

Le circuit 16 peut ainsi être connecté à une seule borne de la source 4. Son intégration en est ainsi facilitée au sein du véhicule 2, notamment par rapport aux circuits de détection de défaut d'isolement connus et basés sur une mesure de résistance au moyen d'un pont diviseur de tension qui requièrent une connexion aux deux bornes de la batterie.

Le circuit 16 permet en outre une détection fiable d'un défaut d'isolement, en particulier par rapport aux méthodes connues qui utilisent un condensateur pour injecter un courant. En effet, ces dernières voient leur précision limitée à cause de la fluctuation dans le temps des propriétés du condensateur.

Enfin, le circuit 16 permet d'obtenir une information sur la position du défaut d'isolement, grâce au calcul du coefficient a. Cela est particulièrement utile dans le cas où la source 4 est formée de multiples accumulateurs 6. En effet, les accumulateurs 6 au sein d'une batterie présentent typiquement chacun une même tension. Grâce au coefficient a, on peut détecter à quel point de l'assemblage de ces accumulateurs se trouve le défaut d'isolement. Le diagnostic et la réparation du défaut d'isolement en sont ainsi améliorés. Par exemple, chaque accumulateur 6 génère une tension Vcell. La position du défaut peut être déterminée en comparant les quantités $\alpha$*Vbat et X*Vcell où X est un entier.

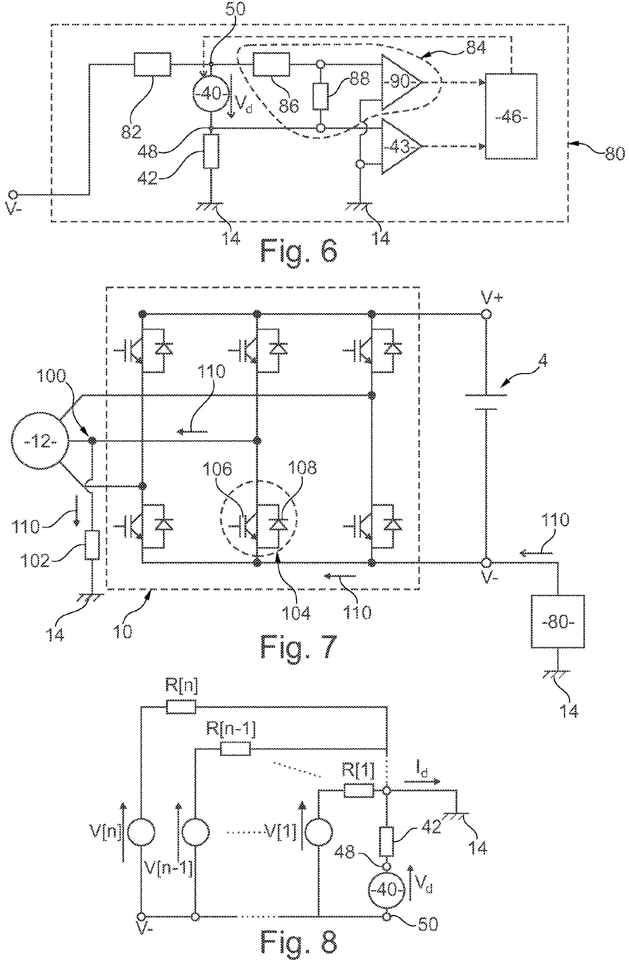

On notera, dans l'exemple représenté en figure 3, que la tension Vd peut être positive ou négative. Avec la convention choisie, et mentionnée ci-dessus, quand la tension Vd est positive, le courant Id peut circuler dans un sens ou dans l'autre, en fonction du positionnement du point 32 dans la source 4 et le potentiel de la carcasse peut être inférieur ou supérieur à celui de la borne V-selon le cas. Un tel double sens possible pour le courant peut complexifier la réalisation du générateur 40 et du circuit de mesure 44. Pour éviter cette éventuelle difficulté, on pourra prévoir d'appliquer une tension Vd négative. Ainsi, le courant Id circulera tout le temps dans le même sens (le courant Id indiqué sur la figure 3 sera alors négatif).La figure 6 représente un circuit 80 apte à remplacer le circuit 16. Ce circuit 80 est par exemple identique au circuit 16, sauf qu'il comporte en outre une résistance 82, par l'intermédiaire de laquelle la borne V- est raccordée électriquement au pôle 50 du générateur 40. Cette résistance 82 joue ici le même rôle que la résistance 52. La valeur Rd de la résistance 82 est de préférence choisie de la même façon que pour la résistance 52. Il en va de même pour la valeur Rs de la résistance 42. Dans cet exemple, Rs est égale à 5kΩ et Rd est égale à 500kΩ. On notera que, comme précédemment pour la figure 3, le courant Id est le courant traversant la résistance 42 (Rs) et qu'il est considéré comme positif quand il circule du générateur 40 vers la carcasse 14.

D'autre part, le circuit 80 comporte en outre un dispositif 84 de mesure de la tension Vd qui est appliquée par le générateur 40.

Le dispositif 84 est particulièrement utile lorsque la valeur de Vd appliquée par le générateur 40 est faible et qu'il risque d'y avoir écart entre valeur de Vd de consigne et la valeur Vd réellement appliquée. Cela pourrait fausser le calcul de Ri. Le dispositif 84 permet aux calculs d'utiliser la valeur de Vd qui est réellement appliquée.

Ici, le dispositif 84 comporte des résistances 86 et 88, connectées en série l'une avec l'autre entre les pôles 48 et 50 pour former un pont diviseur de tension, et un capteur de tension 90.

Par exemple, le capteur 90 comporte un convertisseur de tension analogique/numérique. Les valeurs des résistances 86 et 88, respectivement notées Rp1 et Rp2, sont de préférence choisies de façon à limiter les valeurs de tension mesurées par le capteur 90.

En outre, les résistances 86 et 88 servent également à permettre une circulation du courant électrique Id dans les deux sens. Plus précisément, le générateur délivre un courant (I0+Id) qui se répartit d'une part, en un courant de polarisation I0 qui circule dans les résistances 86 et 88 et d'autre part, en un courant Id qui circule dans la résistance 42 (la source 4 et la résistance d'isolation 34). Le courant de polarisation I0 est prévu supérieur en valeur absolue au courant Id de sorte que le courant I0+Id circule toujours dans le même sens (celui qui est favorable pour le générateur 40) ; la tension aux bornes de la résistance 88 est ainsi toujours polarisée dans le même sens (ce qui facilite la réalisation du circuit 90). Le courant Id peut quant à lui être positif ou négatif selon le signe de la tension Vd et le positionnement du défaut d'isolement.

On notera que dans le cas où on teste la source 4, comme expliqué précédemment, il peut être préférable de choisir une tension Vd négative de sorte que le courant Id soit toujours négatif, ce qui facilite la réalisation du circuit 43.

Dans cet exemple, les valeurs Rp1 et Rp2 sont respectivement égales à 5kΩ et 1kΩ, ce qui fait que la tension mesurée par le capteur 90 reste comprise entre 0V et 5V.

De cette façon, on peut utiliser un capteur 90 de conception plus simple. Par exemple, il n'est pas nécessaire d'avoir recours à un convertisseur différentiel.

Ici, le capteur 90 ne mesure pas directement la tension Vd. Il mesure la valeur Vd*Rp1/(Rp1+Rp2)+Vmes, Vmes étant la valeur de tension mesuré par le dispositif 44. Cependant, la valeur de Vd peut être simplement calculée à partir de la valeur mesurée par le capteur 90, par le dispositif 44 et à l'aide des valeurs de Rp1 et Rp2 qui sont connues.

En outre, dans le circuit 80, dans le cas où la valeur de Vd est négative, il est possible de détecter un défaut d'isolement au niveau de la charge 8, en particulier lorsque cette charge comporte l'onduleur 10 et lorsque ce dernier est à l'arrêt, comme on va le voir plus en détail dans ce qui suit.

La figure 7 représente une portion de l'onduleur 10 utilisé dans le véhicule 2. L'onduleur 10 est alimenté électriquement sur une interface d'entrée de tension continue par la source 4. L'onduleur 10 délivre sur une interface de sortie une tension alternative triphasée pour alimenter le moteur 12, au moyen de connecteurs électriques correspondant chacun à une phase de cette tension. Un défaut d'isolation est ici présent sur un des connecteurs de phase, entre un point 100 de ce connecteur et la carcasse 14. Une résistance 102, de valeur Ri', est associée à ce défaut d'isolement.

De façon connue, l'onduleur 10 comporte une pluralité d'interrupteurs 104 de puissance commandables. La commutation successive de ces interrupteurs 104 assure le fonctionnement de l'onduleur 10. Ici, chacun des interrupteurs 104 comporte :

- un transistor de puissance 106, par exemple de type IGBT (« Insulated Gate Bipolar Transistor » en anglais),
- une diode 108 de roue libre (« flyback diode » en anglais) connectée électriquement entre un collecteur et un émetteur de ce transistor.

Un tel onduleur comporte de façon connue un dispositif de commande et de synchronisation de la commutation des interrupteurs 104. Cette commutation est ici assurée en délivrant un signal de commande sur une grille des transistors 106. Pour faciliter la lecture de la figure 7, ce dispositif n'est cependant pas illustré.

Le circuit 80, grâce à l'inversion du sens de la tension Vd appliquée par le générateur 40, permet de générer un courant Id de sens contraire au sens dans lequel les courants circulent en condition normale dans l'onduleur 10. Le sens et le cheminement de ce courant Id est représenté ici par les flèches 110. Plus précisément, ce courant Id circule au sein de l'onduleur 110 jusqu'à atteindre le point 100 et traverser la résistance 102, en passant par un ou plusieurs des interrupteurs 106. Typiquement, lorsque l'onduleur 10 est à l'arrêt, les transistors 106 sont ouverts et ne permettent pas le passage du courant. Cependant, le courant peut circuler au travers de la diode 108 du fait de son sens de circulation inversé.

Selon un autre mode de réalisation, les circuits 16 et 80 ne sont pas restreints au cas où il n'y a qu'un seul défaut et peuvent être utilisés pour détecter la présence de plusieurs défauts présents simultanément.

La figure 8 représente un circuit électrique équivalent de la source 4 et du circuit 16 en présence d'un nombre n de défauts d'isolation simultanément et en plusieurs points distincts de la source 4. Le nombre n est ici un entier supérieur ou égal à un. Chacun de ces défauts est ici modélisé comme une source de tension V[i] et une résistance R[i] de valeur finie et connectées en série entre elles et entre la borne V- et la carcasse 14, où i est un indice entier compris entre 1 et n. Ces défauts sont connectés en parallèle entre eux entre la carcasse 14 et la borne V- de la source 4. De préférence, les résistances R[i] présentent chacune une valeur inférieure ou égale à n*1MΩ, de sorte que la valeur de la résistance équivalente à ces résistances R[i] en parallèle soit inférieure ou égale à 1MΩ ou à 100kΩ. Pour simplifier, seule une partie du circuit 16, comportant la source 40 et la résistance 42, est représentée sur cette figure 8. En particulier, la résistance 52 n'y est pas représentée.

Alors la valeur du courant Id en présence d'une tension Vd est donnée par la formule suivante :

$$Id = \left( \frac{\sum_{i=1}^{n} \frac{V[i]}{R[i]} + \frac{Vd}{Rd}}{\sum_{i=1}^{n} \frac{1}{R[i]} + \frac{1}{Rd}} \right) * \frac{1}{Rd}$$
[équation 3]

Les valeurs des tensions V[i] et des résistances R[i] peuvent être calculées en appliquant 2*n valeurs différentes de Vd et en mesurant la valeur du courant Id pour chacune d'elles. On obtient alors à partir de l'équation 3 un système de 2*n équations à 2*n inconnues que l'on peut résoudre pour obtenir les n valeurs des tensions V[i] et des résistances R[i]. Par exemple, le module 46 est configuré en conséquence pour réaliser automatiquement ce calcul.

On peut réduire le nombre d'inconnues dans le système d'équations si on forme des hypothèses sur la localisation des défauts d'isolement. Par exemple, on considère que les défauts d'isolement ne peuvent intervenir que du côté de la borne V+ ou V-, ou bien qu'au niveau de connecteurs entre accumulateurs de la batterie formant la source 4. On diminue ainsi le nombre de valeurs de tension Vd à appliquer.

Par exemple, dans le cas particulier où n=2, on peut considérer que les défauts d'isolement ne se produisent qu'aux bornes V+ et V- de la source. Cela se traduit par les conditions suivantes : V[1]=Vbat et V[2]=0V. Seules deux valeurs de Vd, notées Vd1 et Vd2 sont alors nécessaires pour calculer les résistances d'isolement R[1] et R[2] associées respectivement à ces deux défauts, au moyen des formules suivantes :

$$R[1] = [(Vd1 - Vd2)/(Id2 - Id1) - Rd]/\alpha$$
[équation 4]

$$R[2] = [(Vd1 - Vd2)/(Id2 - Id1) - Rd]/(1-\alpha)$$
[équation 5]

où $\alpha$ = R'i/R[1], R'i étant la valeur de la résistance équivalente telle que 1/R'i = 1/R[1] + 1/R[2]. L'expression du coefficient $\alpha$ est par exemple celle donnée à l'équation 2 précédemment décrite.

En pratique, comme le nombre n de défauts n'est généralement pas connu à l'avance, il est possible de choisir un nombre m de valeurs distinctes de valeurs de Vd appliquées par le générateur 40. Ce nombre m n'est pas forcément égal à 2*n. Le nombre m est avantageusement choisi en fonction de la précision que l'on souhaite obtenir.

Par exemple, le procédé de détection est d'abord mis en œuvre avec m=1 puis il est répété pour des valeurs de m croissantes.

Si n est supérieur à un, alors le calcul pour m=1 permet d'obtenir des caractéristiques (valeurs de résistance d'isolement Ri et du coefficient a) d'un unique défaut équivalent aux n défauts. La répétition du procédé avec des valeurs de m plus importantes permet d'affiner la précision des caractéristiques calculées pour ces défauts. On peut alors continuer à appliquer le procédé, successivement, avec des valeurs plus élevées de m, jusqu'à ce que les mesures n'apportent pas de précisions supplémentaires. Cela signifie que l'on a identifié les n défauts.

A l'inverse, dans le cas où la probabilité d'apparition d'un défaut d'isolement à l'intérieur de la source 4 est faible et que le risque de défaut d'isolement porte principalement sur les bornes V+ et V-, on pourra procéder à une détection simplifiée. On pourra par exemple dans un premier temps chercher à détecter si un défaut est présent sur la borne V+, en n'appliquant pas de tension par le générateur (Vd nulle, un courant pouvant circuler à travers le générateur, ou à travers des résistances de polarisation en parallèle du générateur comme en figure 6). Un courant peut ainsi circuler de la borne V+ vers la carcasse, à travers la résistance d'isolation « supérieure » entre la borne V+ et la carcasse, puis rejoindre la borne V- en passant à travers les résistances 52 (ou 82) et 42. Si la résistance d'isolation supérieure est suffisamment faible, alors il sera possible de détecter un courant par le dispositif 44. Si aucun courant n'est détecté alors on peut en conclure que l'isolation supérieure, côté borne V+, est bonne. On peut ensuite tester l'isolation du côté de la borne V-. On notera, en liminaire, que si la résistance d'isolation « inférieure » entre la borne V- et la carcasse est suffisamment faible (notamment par rapport à la résistance d'isolation supérieure), le potentiel de la borne V- tend à être identique à celui de la carcasse et aucun courant ne circule « naturellement » à travers le générateur 40 et les résistances 52 (ou 82) et 42. L'application d'une tension Vd, non nulle, par le générateur 40 permet alors de « forcer » l'application d'une différence de potentiel entre la borne V- et la carcasse et, ainsi, un courant Id non nul va s'établir et pourra être mesuré par le dispositif 44.

De nombreux autres modes de réalisation sont possibles.

Le système électrique comportant la source 4 et le circuit 16 n'est pas limité au véhicule automobile 2 et peut être mis en œuvre dans de nombreux autres systèmes à alimentation électrique pour détecter un défaut d'isolement entre une borne de la source 4 et une carcasse formant une masse électrique flottante de ce système. Il en va de même pour le circuit 80. Notamment, l'utilisation du circuit 80 en conjonction avec l'onduleur 10 n'est pas limitée au véhicule automobile 2 et/ou au moteur 12.

La source 4 peut être différente. Il peut s'agir à titre d'exemple d'un ou plusieurs supercondensateurs. Il peut également s'agir d'un générateur de tension continue tel qu'un panneau photovoltaïque ou bien d'une pile à combustible munie d'un réservoir de carburant.

La valeur de la tension Vbat peut être différente. En variante, la source 4 ne délivre pas une tension continue. Par exemple, la tension Vbat n'est pas constante mais fluctue au cours du temps. Par exemple, la tension Vbat fluctue au sein d'une plage de tensions comprise entre Vbat1 et Vbat2, où Vbat1 est égal à 200V et Vbat2 est égal à 350V. Dans ce cas, le calcul des valeurs de Ri et du coefficient $\alpha$ est modifié en conséquence. Par exemple, l'équation 2 précédemment décrite est modifiée comme suit : $\alpha$ = (Id2*Vd1 - Id1*Vd2)/(Id2*Vbat1 - Id1*Vbat2).

De préférence, la valeur de la tension Vbat fluctue avec une fréquence inférieure ou égale à 50Hz ou à 100Hz.

En variante, la tension Vbat est une tension alternative.

La charge 8 peut être différente. Par exemple, il s'agit d'un moteur électrique à courant continu.

L'onduleur 10 peut être réalisé différemment. En particulier, les interrupteurs 104 peuvent être différents. Par exemple, les transistors 106 sont des transistors MOSFET (« metal field-oxide field effect semiconductor » en anglais) de puissance. Dans ce cas, la diode 108 est formée au sein du composant, de façon connue, par des interfaces de couches de matériau semiconducteur qui forment ce transistor. La diode 108 n'est alors pas nécessairement réalisée par un composant discret. D'autres types de transistors peuvent aussi être utilisés. Le défaut d'isolation peut se trouver à un endroit différent, par exemple, dans le moteur 12.

Le circuit 16 peut être connecté entre la carcasse 14 et la borne V+. Dans ce cas, la connexion du dispositif 39 est modifiée en conséquence.

La résistance 42 peut être placée différemment dans le circuit. Par exemple, le pôle 48 est raccordé à la masse et la résistance est raccordée entre le pôle 50 et la borne V- de la source 4.

Le dispositif 44 peut être différent. Par exemple, le dispositif 44 comporte un capteur de courant à effet Hall ou un capteur de courant à effet Néel qui remplace la résistance 42 et le convertisseur 43.

Les valeurs de Ri, Rd, Rs peuvent être différentes. De même, la valeur de Rd et la valeur du rapport Rd/Rs peuvent être différentes.

Le gestionnaire 28 peut être connecté électriquement à une borne de la source 4, de préférence celle à laquelle le circuit 16 ou 80 est connecté.

Le dispositif 39 peut être différent. Par exemple, le générateur 40 et la résistance 52 sont remplacés par un circuit équivalent (théorème de Norton) comportant une source de courant connectée électriquement en parallèle avec une résistance entre la carcasse 14 et la borne V-.

Les étapes 60, 62 et 64 peuvent être réalisées différemment, en particulier lorsqu'il y a plus d'un défaut.

Le dispositif 84 peut être réalisé différemment.

Les résistances 86 et 88 peuvent être omises.

Le défaut d'isolement peut être ailleurs qu'à l'intérieur de la source 4.

Avantageusement, il est possible de varier la valeur de Vd pas à pas jusqu'à ce que l'on mesure un courant Id nul. On sait que l'on a atteint le défaut lorsque Id = 0.

La tension Vd peut prendre des valeurs différentes, par exemple supérieures à 24V. Il peut être avantageux de choisir des valeurs élevées de Vd, car cela augmente la précision des mesures de Id. Cependant, cela a un impact sur les caractéristiques requises pour le dispositif 44. On recherchera donc un compromis entre la précision des mesures de Id et la simplicité de réalisation des circuits 16 ou 80.

## Revendications

1. Système électrique comportant :

    - des bornes (V+, V-) aptes à être connectées à une source d'énergie électrique (4) embarquée apte à délivrer une tension électrique entre ces bornes ;
    - un circuit de détection d'un défaut d'isolement électrique entre la source d'énergie électrique et une carcasse (14) formant une masse électrique flottante, un défaut d'isolement correspondant à une valeur de résistance anormale d'au moins une résistance d'isolement (Ri) entre la carcasse et au moins un point de la source d'énergie électrique ;
    - un dispositif de mesure (44) d'un courant ;
    - une unité de commande (46) ;

    **caractérisé en ce que** le circuit de détection comporte en outre un générateur de tension commandable (40), relié à ladite carcasse et à une unique première borne parmi lesdites bornes, et apte à polariser la carcasse et l'unique première borne à des potentiels différents ;
et **en ce que** le dispositif de mesure (44) d'un courant est configuré pour mesurer un courant entrant sur ladite première borne et sortant à travers ledit au moins un point de la source, ce courant circulant ensuite à travers ladite au moins une résistance d'isolement jusqu'à ladite carcasse ;

• l'unité de commande (46) est configuré pour :

o◦ commander l'application, par ledit générateur de tension programmable, d'au moins une valeur de tension non nulle entre la carcasse et l'unique première borne,
◦ acquérir au moins une valeur du courant mesuré par ledit dispositif de mesure pour chaque valeur de tension appliquée ;
◦ calculer une valeur d'au moins une résistance d'isolement à partir de ladite au moins une valeur du courant mesuré.

2. Système électrique selon l'une des revendications précédentes, comportant en outre une première résistance électrique (52), cette première résistance et le générateur de tension étant connectés l'un avec l'autre en série entre une desdites bornes et la carcasse, la valeur Rd de la première résistance électrique de protection étant de préférence supérieure à ladite valeur de résistance anormale.

3. Système électrique selon la revendication 2, dans lequel l'unité de commande est apte à calculer la résistance d'isolement associée à un défaut d'isolement équivalent unique, au moyen de la formule suivante :

$$Ri = (Vd1 - Vd2)/(Id2 - Id1) - Rd,$$

où Ri est la valeur de la résistance d'isolement, Id1 et Id2 les valeurs de courant mesurées pour, respectivement, les tensions Vd1 et Vd2 successivement appliquées par ledit générateur.

4. Système électrique selon la revendication 2, dans lequel :

- le circuit de détection est apte à détecter deux défauts d'isolement entre la source de tension (4) et la carcasse ;
- l'unité de commande étant apte à calculer, au moyen des formules suivantes, deux résistances d'isolement R[1] et R[2] associées respectivement auxdits deux défauts d'isolement :

$$R[1] = [(Vd1 - Vd2)/(Id2 - Id1) - Rd]/\alpha$$

$$R[2] = [(Vd1 - Vd2)/(Id2 - Id1) - Rd]/(1-\alpha)$$

où Id1 et Id2 les valeurs de courant mesurées pour, respectivement, les tensions appliquées Vd1 et Vd2 successivement par ledit générateur et $\alpha$ un coefficient compris entre 0 et 1.

5. Système électrique selon l'une quelconque des revendications 2 à 4, dans lequel le dispositif de mesure comporte une seconde résistance (42) de valeur Rs et un dispositif de mesure de la tension aux bornes de la seconde résistance, qui comprend éventuellement un amplificateur différentiel ;
le générateur, la première résistance (52) et la seconde résistance (42), étant placées en série entre la carcasse et ladite unique première borne.

6. Système électrique selon la revendication 5, dans lequel le rapport Rd/Rs entre les valeurs de résistance des première et seconde résistances est compris entre 10 et 100.

7. Système électrique selon l'une quelconque des revendications précédentes, dans lequel le générateur est apte à appliquer une tension électrique entre des premier et second pôles de ce générateur, le premier pôle étant relié à ladite unique première borne (V+, V-), le second pôle étant relié à la carcasse ; dans lequel lesdites bornes sont une borne négative V- et une borne positive V+, le potentiel de la borne V+ étant supérieur au potentiel de la borne V- ; et dans lequel le premier pôle (48) du générateur présente un potentiel électrique plus élevé ou plus faible que celui du second pôle (50) lorsque le générateur applique une tension selon respectivement que le générateur est relié à la borne négative V- ou la borne positive V+, d'où il résulte que le potentiel de la carcasse est respectivement inférieur à celui de la borne V- ou supérieur à celui de la borne V+.

8. Système électrique selon l'une quelconque des revendications précédentes, dans lequel le circuit comporte en outre un dispositif de mesure (84) de la tension délivrée par ledit générateur.

9. Système électrique selon la revendication 8, comprenant des troisième et quatrième résistances (Rp1, Rp2) connectées en série l'une avec l'autre entre des premier et second pôles du générateur pour former un pont diviseur de tension ; et dans lequel ledit dispositif de mesure de tension est connecté électriquement au point médian dudit pont diviseur de tension.

10. Système selon l'une quelconque des revendications précédentes, dans lequel le générateur est configuré pour que ladite tension appliquée soit, en valeur absolue, supérieure ou égale à 0 Volts et inférieure ou égale à 24 Volts.

11. Système selon l'une quelconque des revendications précédentes, dans lequel le générateur est configuré pour que ladite tension appliquée soit une tension continue.

12. Procédé de détection d'un défaut d'isolement entre une source d'énergie électrique embarquée et une carcasse formant une masse électrique flottante, **caractérisé en ce qu'**il comporte les étapes suivantes :

- réalisation d'un système selon l'une des revendications 1 à 11 ;
- application (60) commandée par ladite unité de commande, par ledit générateur de tension programmable, d'au moins une valeur de tension non nulle entre la carcasse et l'unique première borne,
- acquisition (62) par ladite unité de commande d'au moins une valeur du courant mesuré par ledit dispositif de mesure pour chaque valeur de tension appliquée ;
- calcul (64) par ladite unité de commande de la valeur d'au moins une résistance d'isolement à partir de ladite au moins une valeur du courant mesuré.

**Patentansprüche**

1. Elektrisches System aufweisend:

- Anschlüsse (V+, V-), die geeignet sind, an eine bordeigene Quelle elektrischer Energie (4) angeschlossen zu sein, die geeignet ist, eine elektrische Spannung zwischen diesen Anschlüssen zu liefern;
- eine Schaltung zur Detektion eines elektrischen Isolationsfehlers zwischen der Quelle elektrischer Energie und einem Gehäuse (14), das eine schwebende elektrische Masse bildet, wobei ein Isolationsfehler einem anormalen Widerstandswert mindestens eines Isolationswiderstands (Ri) zwischen dem Gehäuse und mindestens einem Punkt der Quelle elektrischer Energie entspricht;
- eine Vorrichtung zur Messung (44) eines Stroms;
- eine Steuereinheit (46);

**dadurch gekennzeichnet, dass** die Detektionsschaltung ferner einen steuerbaren Spannungsgenerator (40) aufweist, der mit dem Gehäuse und einem einzigen ersten Anschluss von den Anschlüssen verbunden ist, und der geeignet ist, das Gehäuse und den einzigen ersten Anschluss auf verschiedene Potentiale zu polarisieren; und dadurch, dass die Vorrichtung zur Messung (44) eines Stroms dazu ausgebildet ist, einen Strom zu messen, der am ersten Anschluss eintritt und durch den mindestens einen Punkt der Quelle austritt, wobei dieser Strom anschließend durch den mindestens einen Isolationswiderstand bis zum Gehäuse strömt; • wobei die Steuereinheit (46) dazu ausgebildet ist:

o das Anlegen, durch den programmierbaren Spannungsgenerator, mindestens eines Spannungswerts ungleich null zwischen dem Gehäuse und dem einzigen ersten Anschluss zu steuern,
o mindestens einen Wert des Stroms zu erfassen, der von der Messvorrichtung für jeden angelegten Spannungswert gemessen wird;
o einen Wert mindestens eines Isolationswiderstands anhand des mindestens einen Werts des gemessenen Stroms zu berechnen.

2. Elektrisches System nach einem der vorhergehenden Ansprüche, ferner aufweisend einen ersten elektrischen Widerstand (52), wobei dieser erste elektrische Widerstand und der Spannungsgenerator zwischen einem der Anschlüsse und dem Gehäuse miteinander in Reihe geschaltet sind, wobei der Wert Rd des ersten elektrischen Schutzwiderstands vorzugsweise größer als der anormale Widerstandswert ist.

3. Elektrisches System nach Anspruch 2 wobei die Steuereinheit geeignet ist, den Isolationswiderstand, der einem einzigen äquivalenten Isolationsfehler zugeordnet ist, mittels der folgenden Formel zu berechnen:

$$Ri = (Vd1 - Vd2)/(Id2 - Id1) - Rd,$$

wobei Ri der Wert des Isolationswiderstands ist, Id1 und Id2 die Stromwerte sind, die jeweils für die Spannungen Vd1 und Vd2 gemessen werden, die nacheinander von dem Generator angelegt werden.

4. Elektrisches System nach Anspruch 2, wobei:

- die Detektionsschaltung geeignet ist, zwei Isolationsfehler zwischen der Spannungsquelle (4) und dem Gehäuse zu detektieren;
- die Steuereinheit geeignet ist, mittels der folgenden Formeln zwei Isolationswiderstände R[1] und R[2] zu berechnen, die jeweils den zwei Isolationsfehlern zugeordnet sind:

$$R[1] = [(Vd1 - Vd2)/(Id2 - Id1) - Rd]/\alpha$$

$$R[2] = [(Vd1 - Vd2)/(Id2 - Id1) - Rd]/(1-\alpha)$$

wobei Id1 und Id2 die Stromwerte sind, die jeweils für die Spannungen Vd1 und Vd2 gemessen werden, die nacheinander vom Generator angelegt werden, und $\alpha$ ein Koeffizient zwischen 0 und 1 ist.

5. Elektrisches System nach einem der Ansprüche 2 bis 4, wobei die Messvorrichtung einen zweiten Widerstand (42) mit dem Wert Rs und eine Vorrichtung zur Messung der Spannung an den Anschlüssen des zweiten Widerstands, die eventuell einen Differenzverstärker umfasst, aufweist; wobei der Generator, der erste Widerstand (52) und der zweite Widerstand (42) zwischen dem Gehäuse und dem einzigen ersten Anschluss in Reihe geschaltet sind.

6. Elektrisches System nach Anspruch 5, wobei das Verhältnis Rd/Rs zwischen den Widerstandswerten des ersten und zweiten Widerstands zwischen 10 und 100 beträgt.

7. Elektrisches System nach einem der vorhergehenden Ansprüche, wobei der Generator geeignet ist, eine elektrische Spannung zwischen einem ersten und zweiten Pol dieses Generators anzulegen, wobei der erste Pol mit dem einzigen ersten Anschluss (V+, V-) verbunden ist, wobei der zweite Pol mit dem Gehäuse verbunden ist; wobei die Anschlüsse ein negativer Anschluss V- und ein positiver Anschluss V+ sind, wobei das Potential des Anschlusses V+ größer als das Potential des Anschlusses V- ist; und wobei der erste Pol (48) des Generators ein höheres oder niedrigeres elektrisches Potential als jenes des zweiten Pols (50) aufweist, wenn der Generator eine Spannung angelegt, je nachdem, ob der Generator mit dem negativen Anschluss V- oder dem positiven Anschluss V+ verbunden ist, woraus hervorgeht, dass das Potential des Gehäuses niedriger als jenes des Anschlusses V- beziehungsweise höher als jenes des Anschlusses V+ ist.

8. Elektrisches System nach einem der vorhergehenden Ansprüche, wobei die Schaltung ferner eine Vorrichtung zur Messung (84) der Spannung aufweist, die vom Generator geliefert wird.

9. Elektrisches System nach Anspruch 8, umfassend einen dritten und vierten Widerstand (Rp1, Rp2), die zwischen einem ersten und zweiten Pol des Generators miteinander in Reihe geschaltet sind, um eine Spannungsteilerbrücke zu bilden; und wobei die Spannungsmessvorrichtung mit dem Mittelpunkt der Spannungsteilerbrücke elektrisch verbunden ist.

10. System nach einem der vorhergehenden Ansprüche, wobei der Generator dazu ausgebildet ist, dass die angelegte Spannung im Absolutwert größer als oder gleich 0 Volt und kleiner als oder gleich 24 Volt ist.

**11.** System nach einem der vorhergehenden Ansprüche, wobei der Generator dazu ausgebildet ist, dass die angelegte Spannung eine Gleichspannung ist.

**12.** Verfahren zur Detektion eines Isolationsfehlers zwischen einer bordeigenen Quelle elektrischer Energie und einem Gehäuse, das eine schwebende elektrische Masse bildet, **dadurch gekennzeichnet, dass** es die folgenden Schritte aufweist:

- Herstellen eines Systems nach einem der Ansprüche 1 bis 11;
- Anlegen (60), gesteuert durch die Steuereinheit, mindestens eines Spannungswerts ungleich null zwischen dem Gehäuse und dem einzigen ersten Anschluss, durch den programmierbaren Spannungsgenerator,
- Erfassen (62), durch die Steuereinheit, mindestens eines Werts des Stroms, der von der Messvorrichtung für jeden angelegten Spannungswert gemessen wird;
- Berechnen (64), durch die Steuereinheit, des Werts mindestens eines Isolationswiderstands anhand des mindestens einen Werts des gemessenen Stroms.

**Claims**

**1.** Electrical system comprising:

- terminals (V+, V-) able to be connected to an onboard electric power source (4) designed to deliver a voltage between these terminals;
- a circuit for detecting an electrical insulation fault between the electrical power source and a body (14) forming a floating electrical ground, an insulation fault corresponding to an abnormal resistance value in at least one insulation resistance (Ri) between the body and at least one point of the electrical power source,
- a device (44) for measuring a current;
- a control unit (46);

**characterized in that** the detection circuit further comprises a controllable voltage generator (40), connected to said body and to a single first terminal from among said terminals and designed to bias the body and the single first terminal at different potentials;

and **in that** the device (44) for measuring a current is configured to measure a current incoming onto said first terminal and outgoing across said at least one point of the source, this current subsequently flowing through said at least one insulation resistance to said body;

the control unit (46) is configured to:

o control the application, by said programmable voltage generator, of at least one non-zero voltage value between the body and the single first terminal,
o acquire at least one value of the current measured by said measurement device for each applied voltage value;
o calculate a value of at least one insulation resistance based on said at least one measured value of the current.

**2.** Electrical system according to one of the preceding claims, further comprising a first electrical resistance (52), this first resistance and the voltage generator being connected in series with one another between one of said terminals and the body, the value Rd of the first protection electrical resistance being preferably higher than said abnormal value of resistance.

**3.** Electrical system according to Claim 2, wherein the control unit is capable of calculating the insulation resistance associated with a single equivalent insulation fault, by means of the following formula:

$$Ri = (Vd1 - Vd2)/(Id2 - Id1) - Rd,$$

where Ri is the value of the insulation resistance, Id1 and Id2 the measured current values for, respectively, the voltages Vd1 and Vd2 successively applied by said generator.

**4.** Electrical system according to Claim 2, wherein:

- the detection circuit is capable of detecting two insulation faults between the voltage source (4) and the body;
- the control unit being capable of calculating, by means of the following formulas, two insulation resistances R[1] and R[2] respectively associated with said two insulation faults:

$$R[1] = [(Vd1 - Vd2)/(Id2 - Id1) - Rd]/\alpha$$

$$R[2] = [(Vd1 - Vd2)/(Id2 - Id1) - Rd]/(1-\alpha)$$

where Id1 and Id2 are the measured current values for, respectively, the voltages Vd1 and Vd2 successively applied by said generator and $\alpha$ is a coefficient in the range between 0 and 1.

5. Electrical system according to any one of Claims 2 to 4, wherein the measurement device comprises a second resistance (42) with a value Rs and a device for measuring the voltage across the terminals of the second resistance, which potentially comprises a differential amplifier;
the generator, the first resistance (52) and the second resistance (42), being placed in series between the body and said single first terminal.

6. Electrical system according to Claim 5, wherein the ratio Rd/Rs between the resistance values of the first and second resistances is in the range between 10 and 100.

7. Electrical system according to any one of the preceding claims, wherein the generator is designed to apply a voltage between first and second poles of this generator, the first pole being connected to said single first terminal (V+, V-), the second pole being connected to the body; wherein said terminals are a negative terminal V- and a positive terminal V+, the potential of the terminal V+ being higher than the potential of the terminal V-; and wherein the first pole (48) of the generator has an electrical potential higher or lower than that of the second pole (50) when the generator applies a voltage depending on whether the generator is connected to the negative terminal V- or to the positive terminal V+, respectively, which results in the potential of the body being lower than that of the terminal V- or higher than that of the terminal V+, respectively.

8. Electrical system according to any one of the preceding claims, wherein the circuit further comprises a device (84) for measuring the voltage delivered by said generator.

9. Electrical system according to Claim 8, comprising third and fourth resistances (Rp1, Rp2) connected in series with one another between first and second poles of the generator so as to form a voltage divider bridge; and wherein said voltage measurement device is electrically connected to the midpoint of said voltage divider bridge.

10. System according to any one of the preceding claims, wherein the generator is configured such that said applied voltage is, in absolute value, higher than or equal to 0 volts and lower than or equal to 24 volts.

11. System according to any one of the preceding claims, wherein the generator is configured such that said applied voltage is a DC voltage.

12. Method for detecting an insulation fault between an onboard electrical power source and a body forming a floating electrical ground, **characterized in that** it comprises the following steps:

- implementation of a system according to one of Claims 1 to 11;
- application (60), controlled by said control unit, by said programmable voltage generator, of at least one non-zero voltage value between the body and the single first terminal,
- acquisition (62), by said control unit, of at least one value of the current measured by said measurement device for each applied voltage value;
- calculation (64), by said control unit, of the value of at least one insulation resistance based on said at least one measured value of the current.

Fig. 1

$$(1-\alpha)V_{bat}$$

$$\alpha V_{bat}$$

Fig. 2

Fig. 3

Fig. 4

Fig. 5

Fig. 6

Fig. 7

Fig. 8

## RÉFÉRENCES CITÉES DANS LA DESCRIPTION

**Documents brevets cités dans la description**

- WO 2014086381 A
- US 20130300430 A
- FR 2976084
- US 20130314097 A